Europäisches Patentamt

European Patent Office

Office européen des brevets

(19)

(11) Veröffentlichungsnummer: **0 038 951**
**B1**

(12) EUROPÄISCHE PATENTSCHRIFT

(45) Veröffentlichungstag der Patentschrift:
22.02.84

(51) Int. Cl.³: **H 01 L 21/00, H 01 L 21/265**

(21) Anmeldenummer: **81102468.6**

(22) Anmeldetag: **01.04.81**

(54) Verfahren zur Herstellung von Fotolackstrukturen für integrierte Halbleiterschaltungen.

(30) Priorität: **25.04.80 DE 3016050**

(43) Veröffentlichungstag der Anmeldung:
**04.11.81 Patentblatt 81/44**

(45) Bekanntmachung des Hinweises auf die Patenterteilung:
**22.02.84 Patentblatt 84/8**

(84) Benannte Vertragsstaaten:
**FR GB**

(56) Entgegenhaltungen:
**FR - A - 2 260 187**
**US - A - 3 928 082**

**IBM TECHNICAL DISCLOSURE BULLETIN, Band 13, Nr. 5, Oktober 1970, Seite 1049 New York, U.S.A. H.S. BHATIA et al.: "Contact hole photoresist masking"**
**IBM TECHNICAL DISCLOSURE BULLETIN, Band 14, Nr. 1, Juni 1971, Seite 346 New York, U.S.A. V.T. ALEXOPOULOS: "Emitter masking technique"**

(73) Patentinhaber: **SIEMENS AKTIENGESELLSCHAFT, Berlin und München Wittelsbacherplatz 2, D-8000 München 2 (DE)**

(72) Erfinder: **Sigusch, Reiner, Mainaustrasse 71, D-8000 München 60 (DE)**

## Verfahren zur Herstellung von Fotolackstrukturen für integrierte Halbleiterschaltungen

Die vorliegende Patentanmeldung betrifft ein Verfahren zur Herstellung von Strukturen aus Fotolackschichten auf für integrierte Halbleiterschaltungen vorgesehenen Substraten, bei deren Herstellung unmittelbar aufeinanderfolgend Fotolithografieprozesse zur Herstellung der als Maskierung dienenden Strukturen ohne Zwischenschalten von Hochtemperaturprozessen durchgeführt werden, wobei die zuerst aufgebrachte Fotolackmaske von der nachfolgend aufzubringenden Fotolackschicht überschichtet wird.

In der Prozeßfolge zur Herstellung von integrierten Halbleiterschaltungen auf Siliziumkristallscheiben sind Fotolithografieschritte enthalten. Dabei dient eine Fotolackschicht zur Maskierung und/oder Strukturierung der Halbleiteroberfläche. Auf eine mit einer Siliziumdioxidschicht ganzflächig überzogenen Siliziumkristallscheibe wird z. B. eine Fotolackschicht eines positiv arbeitenden Fotolacks aufgebracht und mittels einer Maske belichtet und entwickelt. Die so erzeugte Fotolackmaske kann dann entweder bei nachfolgenden Ätzprozessen zur Strukturierung der darunter befindlichen Siliziumdioxidschicht dienen oder selbst direkt als Maske gegen die in die Siliziumkristallscheibe zu implantierenden Dotierstoffe eingesetzt werden.

Folgen im Prozeßablauf zwei solcher Fotolithografieschritte unmittelbar aufeinander, dann kann die Haftung der zweiten Fotolackschicht auf dem Substrat (in diesem Falle auf dem Oxid), wenn keine Hochtemperaturprozesse dazwischenliegen, so ungenügend werden, daß während des Entwicklungsprozesses bzw. während des Spülens nach dem Entwickeln sich die erzeugten Fotolackstrukturen verschieben oder sogar ablösen.

Um das Ablösen oder Abheben der Fotolackstrukturen zu vermeiden, entfernt man die erste Fotolackschicht ganz, reinigt die Siliziumkristallscheibe und tempert die Scheibe z. B. 1 Stunde lang bei z. B. 300° C in Stickstoffatmosphäre, bevor man nach dem Aufbringen eines Haftvermittlers die zweite Fotolackschicht erzeugt wird. Durch die gründliche Reinigung, das Tempern und das Aufbringen eines Haftvermittlers wird eine ausreichende Haftung der zweiten Fotolackschicht auf der mit z. B. Siliziumdioxid versehenen Siliziumkristallscheibe erreicht.

Aus der US-A-3 928 082 ist ein Verfahren zur Herstellung von für Transistoren verwendbaren Strukturen aus Fotolackschichten bekannt, bei dem nacheinander Fotolithografieprozesse zur Herstellung der als Maskierung dienenden Strukturen ohne Zwischenschalten von Hochtemperaturprozessen durchgeführt werden. Dabei wird die zuerst aufgebrachte Fotolackmaske zunächst von einem Lösungsmittel entfernt und dann die zweite Fotolackschicht ganzflächig aufgebracht und strukturiert.

Ein Verfahren der eingangs genannten Art ist aus dem IBM TECHNICAL DISCLOSURE BULLETIN, Band 13, Nr. 5, Oktober 1970, Seite 1049 bekannt. Bei diesem Verfahren wird eine erste strukturierte Lackschicht von einer zweiten Lackschicht überschichtet, die dann auch strukturiert wird.

Ein ähnliches Verfahren ist auch aus der gleichen Zeitschrift, Band 14, Nr. 1, Juni 1971, Seite 346 zu entnehmen. Hier werden zwei verschiedene, aus positiv und negativ arbeitenden Fotolacken bestehende Schichten verwendet.

Die Erfindung beschreitet einen anderen Weg, um eine ausreichende Haftung der zweiten Fotolackschicht auf der z. B. mit einer Oxidschicht versehenen Siliziumsubstratscheibe zu erzielen.

Dieser Weg besteht erfindungsgemäß darin, daß bei einem Verfahren der eingangs genannten Art die nachfolgend aufzubringende Fotolackschicht ein Lösungsmittel zur Auflösung der ersten Fotolackmaske enthält, so daß aus den beiden ersten Fotolackschichten eine neue homogene Fotolackschicht entsteht, die bis zur gewünschten Dicke abgetragen und dann strukturiert wird.

Gemäß einem Ausführungsbeispiel der Erfindung ist vorgesehen, daß für die Fotolithografieprozesse Fotolacke mit gleichen oder ähnlichen Lösungsmittelanteilen verwendet werden.

Um die Haftfestigkeit noch weiter zu verbessern und zum Ausdampfen des im Fotolack enthaltenen Lösungsmittels, wird vor dem Belichten und Entwicklen, der vorzugsweise auf 0,5 bis 2,5 µm Dicke eingestellten neuen Fotolackschicht, eine Temperaturbehandlung bei 50° bis 120° C und nach dem Belichten, Entwickeln und Spülen eine Temperaturbehandlung bei 50° bis 150° C durchgeführt.

Das Verfahren nach der Lehre der Erfindung hat gegenüber den bekannten Verfahren, insbesondere wie sie aus dem IBM TECHNICAL DISCLOSURE BULLETIN, Band 13, Nr. 5, Oktober 1970, Seite 1049 und Band 14, Nr. 1, Juni 1971, Seite 346 zu entnehmen sind und bei denen die beiden Lackschichten nicht ineinander löslich sind, den Vorteil, daß durch die vollkommene Auflösung der ersten Fotolackmaske in der zweiten Fotolackschicht wenige Prozeßschritte zur Erzeugung der Strukturen erforderlich sind, und daß eine, durch zusätzliche Verfahrensschritte bedingte Verunreinigung der Subtratscheiben ausgeschlossen wird, wodurch eine höhere Ausbeute an funktionsfähigen Schaltungen erhalten wird.

Das Verfahren nach der Lehre der Erfindung, welches beliebig wiederholbar ist, ist anwendbar auf alle Prozesse der Halbleitertechnologie, bei denen unmittelbar nacheinander Fotolithografieverfahren zur Erzeugung von Fotolackmaskierungen durchgeführt werden müssen, um z. B. nacheinander durch Ionenimplantation unterschiedliche Kanalbereiche des Substrates zu dotieren. Ein solcher Prozeß wird beispielsweise im IEDM Digest of Technical Paper vom Dezember 1979, Seiten 352–354, beschrieben. Das Verfahren ist auch vorteilhaft verwendbar beim Aufbringen der Metallisierung nach der lift-off-Technik, wobei die Kontaktlochmaske in der Fotolackschicht, die zur Strukturierung der lift-off-Maske dient, aufgelöst wird.

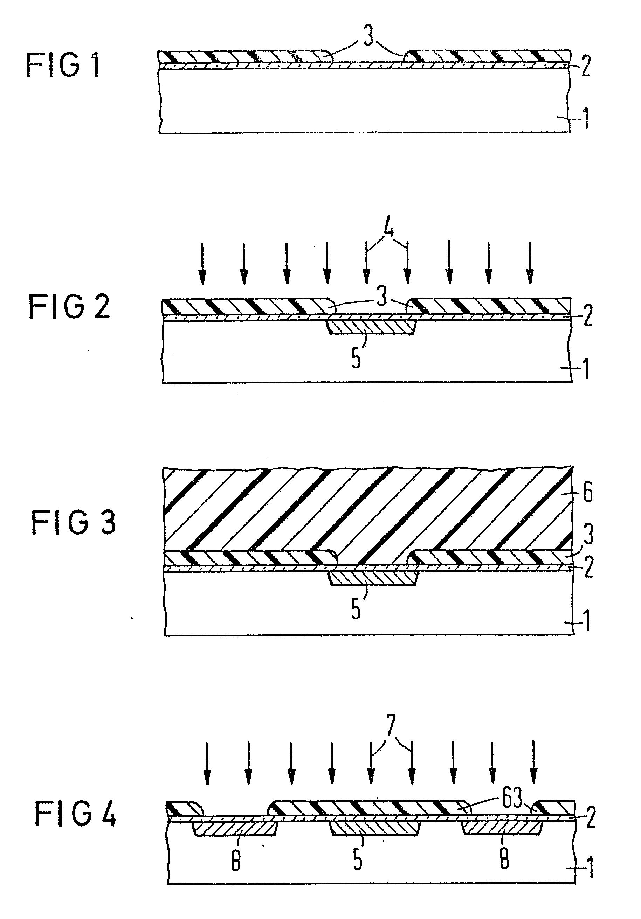

Im folgenden wird anhand der Fig. 1 bis 4 und eines einfachen Ausführungsbeispiels das Verfahren nach der Lehre der Erfindung näher erläutert.

Auf eine mit einer 50 nm dicken Siliziumdioxidschicht 2 ganzflächig überzogenen Siliziumkristallscheibe 1 wird eine 1,0 µm dicke Fotolackschicht 3 eines positiv arbeitenden Fotolackes (z. B. Shipley's AZ 1350 H) aufgebracht und durch Belichten und Entwickeln so strukturiert, daß die in Fig. 1 dargestellte Anordnung entsteht.

Die auf dem Substrat 1, 2 befindliche Lackmaske 3 wird, wie in Fig. 2 dargestellt, als Implantationsmaske für eine Borimplantation (siehe Pfeil 4) zur Erzeugung einer p-dotierten Zone 5 in der Siliziumkristallscheibe 1 verwendet. Anstelle von Bor kann auch Arsen verwendet werden.

Nach erfolgter Implantation wird, wie aus Fig. 3 ersichtlich ist, die mit der Fotolackstruktur 3 (erste Fotolackmaske) versehene Anordnung 1, 2, 3, 5 ganzflächig mit einer positiv arbeitenden Fotolackschicht 6 bedeckt, wobei sich im ganzflächig auf die erste Fotolackmaske 3 aufgebrachten Fotolack 6 die Fotolackmaske 3 vollständig auflöst.

Zur Erzeugung einer 1,0 µm dicken Fotolackschicht 63 wird der überschüssige Fotolack der Schicht 6 abzentrifugiert.

Nach Belichtung und Entwicklung der Fotolackschicht 63 erscheint die in Fig. 4 dargestellte Anordnung, bei der die nun entstandene Fotolackmaske 63 als Implantationsmaske für eine nachfolgende Arsenimplantation (siehe Pfeile 7) zur Erzeugung von n-dotierten Zonen 8 in der Siliziumkristallscheibe 1 verwendet wird. Anstelle von Arsen kann auch Bor verwendet werden.

## Patentansprüche

1. Verfahren zur Herstellung von Strukturen aus Fotolackschichten auf für integrierte Halbleiterschaltungen vorgesehenen Substraten (1), bei deren Herstellung unmittelbar aufeinanderfolgend Fotolithografieprozesse zur Herstellung der als Maskierung dienenden Strukturen ohne Zwischenschalten von Hochtemperaturprozessen durchgeführt werden, wobei die zuerst aufgebrachte Fotolackmaske (3) von der nachfolgend aufzubringenden Fotolackschicht (6) überschichtet wird, dadurch gekennzeichnet, daß die nachfolgend aufzubringende Fotolackschicht (6) ein Lösungsmittel zur Auflösung der ersten Fotolackmaske (3) enthält, so daß aus den beiden ersten Fotolackschichten (3, 6) eine neue homogene Fotolackschicht entsteht, die bis zur gewünschten Dicke abgetragen und dann strukturiert wird (63).

2. Verfahren nach Anspruch 1, dadurch gekennzeichnet, daß für die Fotolithografieprozesse Fotolacke mit gleichen oder ähnlichen Lösungsmittelanteilen verwendet werden.

3. Verfahren nach einem der Ansprüche 1 bis 2, dadurch gekennzeichnet, daß vor dem Belichten und Entwickeln der neuen Fotolackschicht eine Temperaturbehandlung bei 50° C bis 120° C und nach dem Belichten, Entwickeln und Spülen eine Temperaturbehandlung bei 50° C bis 150° C durchgeführt wird.

4. Verfahren nach einem der Ansprüche 1 bis 3, dadurch gekennzeichnet, daß die Dicke der neuen Fotolackschicht auf 0,5 bis 2,5 µm eingestellt wird.

5. Verwendung des Verfahrens nach einem der Ansprüche 1 bis 4 zur Herstellung von integrierten Halbleiterschaltungen, bei denen unmittelbar nacheinander mindestens zwei Kanalimplantationen in verschiedene Bereiche des Substrats gegebenenfalls mit unterschiedlichen Dotierstoffen vorgenommen werden.

6. Verwendung des Verfahrens nach einem der Ansprüche 1 bis 4 zur Herstellung von integrierten Halbleiterschaltungen beim Aufbringen der Metallisierung nach der lift-off-Technik.

## Claims

1. A process for the production of structures made of photolacquer layers on substrates (1) provided for integrated semiconductor circuits, in the production of which photolithographic processes for the production of the structures serving as masks are carried out in direct succession without intermediate high-temperature processes, in which the photolacquer mask (3) first applied is covered by the photolacquer layer (6) which is to be subsequently applied, characterised in that the subsequently applied photolacquer layer (6) contains a solvent which acts to dissolve the first photolacquer mask (3), so that a new homogeneous photolacquer layer is produced from the two first photolacquer layers (3, 6,), which new layer is removed until the required thickness has been reached and is subsequently structured (63).

2. A process according to Claim 1, characterised in that photolacquers having identical or similar proportions of solvent are used for the photolithographic processes.

3. A process according to Claim 1 or Claim 2, characterised in that, prior to the exposure and development of the new photolacquer layer a heat treatment is carried out at 50° C to 120° C and, after exposure, development and rinsing, a heat treatment at 50° C to 150° C is carried out.

4. A process according to one of Claims 1 to 3, characterised in that the thickness of the new

photolacquer layer is adjusted to from 0.5 to 2.5 µm.

5. The use of the process according to one of Claims 1 to 4 for the production of integrated semiconductor circuits, wherein at least two channel implantations are carried out in direct succession in different regions of the substrate, if necessary with different dopants.

6. The use of the process according to one of Claims 1 to 4 for the production of integrated semiconductor circuits during the application of the metallization in accordance with the lift-off technique.

## Revendications

1. Procédé pour fabriquer des structures formées de couches de vernis photosensible sur des substrats (1) prévus pour des circuits intégrés à semiconducteurs et pour lesquels on met en oeuvre des processus de photolitographie se succédant directement pour fabriquer les structures servant de masquage, sans intercaler des processus à haute température, le masque de vernis photosensible (3) déposé en premier lieu étant recouvert par la couche de vernis photosensible (6) devant être déposé ultérieurement, caractérisé par le fait que la couche de vernis photosensible (6) devant être déposée ultérieurement contient un solvant servant à dissoudre le premier masque de vernis photosensible (3), de sorte qu'à partir des deux premières couches de vernis photosensible (3, 6) il apparaît une nouvelle couche de vernis photosensible homogène que l'on réduit jusqu'à l'épaisseur désirée et que l'on structure ensuite (63).

2. Procédé suivant la revendication 1, caractérisé par le fait que pour les processus de photolithographie, on utilise des vernis photosensibles possédant des pourcentages identiques ou semblables de solvants.

3. Procédé suivant l'une des revendications 1 ou 2, caractérisé par le fait qu'avant l'exposition et le développement de la nouvelle couche de vernis photosensible, on effectue un traitement thermique entre 50 et 120°C et qu'après l'exposition, le développement et le lavage, on effectue un traitement thermique entre 50 et 150°C.

4. Procédé suivant l'une des revendications 1 à 3, caractérisé par le fait que l'épaisseur de la nouvelle couche de vernis photosensible est réglée entre 0,5 et 2,5 µm.

5. Utilisation du procédé suivant l'une des revendications 1 à 4, pour fabriquer des circuits intégrés à semiconducteurs, dans lesquels on réalise directement à la suite l'une de l'autre au moins deux implantations de canal dans des zones différentes du substrat, éventuellement avec des substances dopantes différentes.

6. Utilisation du procédé suivant l'une des revendications 1 à 4, pour fabriquer des circuits intégrés à semiconducteurs dans le cas du dépôt de la métallisation selon la technique lift-off.

FIG 1

FIG 2

FIG 3

FIG 4